# EUROPÄISCHE PATENTSCHRIFT

(11) **EP 1 151 539 B1**
(45) Veröffentlichungstag und Bekanntmachung des Hinweises auf die Patenterteilung: **02.04.2003**
(21) Anmeldenummer: 00908937.6
(22) Anmeldetag: 26.01.2000
(51) Int. Cl.: H03K 17/12

(54) **VERFAHREN UND VORRICHTUNG ZUR SYMMETRIERUNG DER VERLUSTLEISTUNG MEHRERER PARALLEL GESCHALTETER KASKODENSCHALTUNGEN**
METHOD AND DEVICE FOR BALANCING THE POWER LOSS IN SEVERAL CASCODE CIRCUITS CONNECTED IN PARALLEL
PROCEDE ET DISPOSITIF POUR L'EQUILIBRAGE DE LA PERTE DE PUISSANCE DE PLUSIEURS CIRCUITS DE CASCODES MONTES EN PARALLELE

(30) Priorität: 08.02.1999 DE 19905078
(43) Veröffentlichungstag der Anmeldung: 07.11.2001
(73) Patentinhaber: SIEMENS AKTIENGESELLSCHAFT, 80333 München (DE)
(72) Erfinder: BAUDELOT, Eric, D-91085 Weisendorf (DE); BRUCKMANN, Manfred, D-90475 Nürnberg (DE); MITLEHNER, Heinz, D-91080 Uttenreuth (DE); WEIS, Benno, D-91334 Hemhofen (DE)
(86) Internationale Anmeldenummer: DE0000219
(87) Internationale Veröffentlichungsnummer: WO00048316

(56) Entgegenhaltungen:
- EP-A- 0 419 993
- GB-A- 2 260 625
- US-A- 5 396 085

## Beschreibung

Die Erfindung bezieht sich auf ein Verfahren und eine Vorrichtung zur Symmetrierung der Verlustleistung wenigstens zweier elektrisch parallel geschalteter Kaskodenschaltungen, die jeweils einen niedersperrenden Halbleiterschalter aus Silizium und einen hochsperrenden Halbleiterschalter aus Siliziumkarbid aufweisen.

Eine derartige Kaskodenschaltung ist aus dem deutschen Patent 196 10 135 bekannt. Diese Kaskodenschaltung weist einen selbstsperrenden n-Kanal-MOSFET, insbesondere einen Niedervolt-Leistungs-MOSFET, und einen hochsperrenden Sperrschicht-FET, der auch als Junction-Field-Effect-Transistor (JFET) bezeichnet wird, auf. Diese Kaskodenschaltung wird auch als Hybrid-Leistungs-MOSFET bezeichnet und ist für eine hohe Sperrspannung von über 600 V ausgelegt, wobei dieser dennoch nur geringe Verluste im Durchlaßbereich aufweist.

Diese beiden FET dieser bekannten Kaskodenschaltung sind derart elektrisch in Reihe geschaltet, daß der Source-Anschluß des Sperrschicht-FET mit dem Drain-Anschluß des MOSFET und daß der Gate-Anschluß des Sperrschicht-FET mit dem Source-Anschluß des MOSFET elektrisch leitend verbunden sind. Der selbstsperrenden n-Kanal-MOSFET ist aus Silizium, wogegen der selbstsperrende n-Kanal-JFET aus Siliziumkarbid besteht.

Gesteuert wird diese Kaskodenschaltung mittels der Gate-Spannung des selbstsperrenden MOSFET. Ist dieser MOSFET eingeschaltet, so ist seine Drain-Spannung näherungsweise Null und durch die Gegenkopplung dieser Drain-Spannung ist die Gate-Spannung des selbstleitenden JFET ebenfalls Null. Bei einem selbstleitenden Sperrschicht-FET fließt bei einer Gate-Spannung gleich Null der maximale Drain-Strom. Wird der selbstsperrende MOSFET abgeschaltet, so steigt seine Drain-Spannung und die Gate-Spannung des selbstleitenden Sperrschicht-FET fällt durch die Gegenkopplung. Sobald die Gate-Spannung des Sperrschicht-PET eine Schwellenspannung erreicht bzw. unterschreitet, ist der Drain-Strom dieses Sperrschicht-FET Null. Somit ist diese Kaskodenschaltung abgeschaltet.

Derartige Kaskodenschaltungen können grundsätzlich parallelgeschaltet werden. Bei der Parallelschaltung mehrerer Halbleiterschalter tritt das Problem auf, daß der zu führende Laststrom sich nicht gleichmäßig auf die parallel geschalteten Halbleiterschalter aufteilt. Diese ungleichmäßige Stromaufteilung resultiert aus fertigungstechnischen Gründen des Halbleiterschalters.

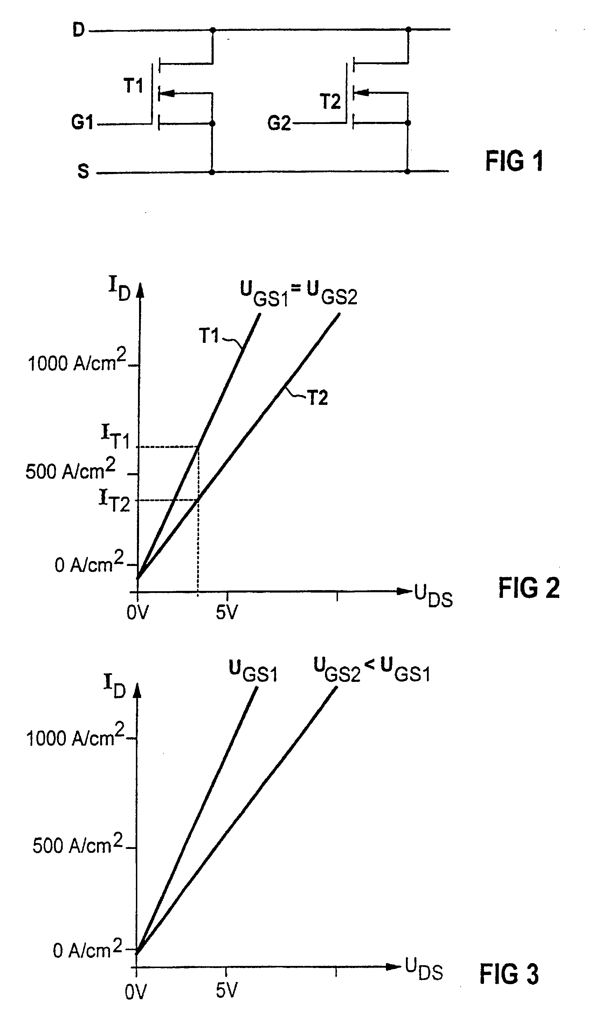

Das Problem der ungleichmäßigen Stromaufteilung parallel geschalteter Halbleiterschalter wird am Beispiel der Parallelschaltung zweier Halbleiterschalter T1 und T2, insbesondere zweier MOSFET, erläutert (FIG 1). In der FIG 2 sind die zugehörigen Ausgangskennlinien dieser beiden MOSFET T1 und T2 in einem Diagramm dargestellt. Diese Ausgangskennlinien der parallel geschalteten MOSFET T1 und T2 ergeben sich bei zwei Gate-Spannungen, die gleich sind. Diesem Diagramm ist zu entnehmen, daß die Ausgangskennlinien der beiden MOSFET T1 und T2 bei gleicher Gate-Spannung voneinander abweichen. Diese Abweichung ist fertigungstechnisch begründet. In dem dargestellten Fall teilt sich ein Laststrom von 1000 A/cm² nicht gleichmäßig auf die beiden parallel geschalteten MOSFET T1 und T2 auf, sondern der MOSFET T1 führt einen größeren Stromanteil als der MOSFET T2. Der MOSFET T1 führt einen Teilstrom I_{T1} von 600 A/cm² und der MOSFET T2 einen Teilstrom I_{T2} von 400 A/cm². Da über beiden Halbleiterschaltern T1 und T2 wegen der Parallelschaltung die gleiche Durchlaßspannung anliegt, wird im Halbleiterschalter T1 infolge des größeren Teilstromes I_{T1} eine höhere Verlustleistung umgesetzt. Eine derartige erhöhte Verlustleistung kann u.U. diesen Halbleiterschalter T1 zerstören, zumindest beschädigen.

Dieses Problem kann dadurch gelöst werden, daß die gesamte Stromauslastung mehrerer parallel geschalteter Halbleiterschalter so begrenzt wird, daß bei einer maximalen vom Hersteller garantierten Unsymmetrie kein Halbleiterschalter der Parallelschalter überlastet wird. Diese Lösung besitzt jedoch den Nachteil, daß die Parallelschaltung mehrerer Halbleiterschalter stark überdimensioniert werden muß und somit nicht sehr wirtschaftlich ist.

Die Halbleiterschalter können vom Hersteller so dimensioniert werden, daß diese einen positiven Temperaturkoeffizienten besitzen. In der Veröffentlichung "A New Generation of 600 V IGBT-Modules", abgedruckt im Konferenzband "POWER CONVERSION", Mai 1998, Seiten 23 bis 31; wird ein IGBT-Modul vorgestellt, daß einen positiven Temperaturkoeffizienten aufweist. Ebenfalls wird in dieser Veröffentlichung darauf hingewiesen, daß derartige Halbleiterschalter besonders vorteilhaft bei Parallelschaltungen eingesetzt werden können. Mit einem derartig ausgebildeten Halbleiterschalter kann die Verlustleistung parallel geschalteter Halbleiterschalter nicht vollständig symmetriert werden. Außerdem erfolgt dieser Ausgleichsmechanismus infolge des positiven Temperaturkoeffizienten mit großer Zeitkonstante. Besonders bei bipolaren Halbleiterschaltern schränkt diese Forderung des positiven Temperaturkoeffizienten die übrige Halbleiterschalteroptimierung ein. Das angesprochene Problem wird auf diesem Wege nur abgemildert, aber nicht vollständig gelöst.

Diese geschilderte Problematik tritt nicht nur bei parallel geschalteten MOSFET T1 und T2 auf, sondern allgemein bei parallel geschalteten Halbleiterschaltern. Bei einen Halbleiterschalter, der aus zwei Halbleiterschaltern zusammengesetzt ist, beispielsweise die eingangs erwähnte Kaskodenschaltung, kann dieses Problem mit den herkömmlichen Mitteln nicht gelöst werden, da jeder Halbleiterschalter einer Kaskodenschaltung für die Verwendung in der Kaskodenschaltung optimiert worden ist.

Der Erfindung liegt nun die Aufgabe zugrunde, ein Verfahren und eine Vorrichtung zur Symmetrierung der Verlustleistung mehrerer parallel geschalteter Kaskodenschaltungen anzugeben.

Diese Aufgabe wird erfindungsgemäß gelöst mit den Merkmalen des Anspruchs 1 bzw. 7.

Dadurch, daß eine Ausgangsspannung eines jeden niedersperrenden Halbleiterschalters der parallel geschalteten Kaskodenschaltungen erfaßt werden, hat man ein Signal für den in den parallel geschalteten Kaskodenschaltungen fließenden: Strom. Somit ist die Stromaufteilung für eine Parallelschaltung mehrerer Kaskodenschaltungen bekannt. Um diese ermittelte Stromaufteilung aktiv zu symmetrieren, wird die Tatsache ausgenutzt, daß sich die Ausgangsspannung des niedersperrenden Leistungshalbleiterschalters mit der Steuergröße als Parameter verändert. Dazu werden in Abhängigkeit der ermittelten Ausgangsspannungen der niedersperrenden Halbleiterschaltern der parallel geschalteten Kaskodenschaltungen Korrekturwerte bestimmt, die korrespondierenden Steuersignalen der niedersperrenden Halbleiterschalter überlagert werden. Mittels dieser Korrekturwerte werden die Steuersignale der niedersperrenden Halbleiterschalter derart verändert, daß sich die Ausgangsspannungen der parallel geschalteten Kaskodenschaltungen angleichen. Dadurch symmetriert sich die Stromaufteilung dieser Parallelschaltung mehrerer parallel geschalteter Kaskodenschaltungen.

Eine zugehörige Vorrichtung zur Symmetrierung der Verlustleistung mehrerer parallel geschalteter Kaskodenschaltungen weist für jede Kaskodenschaltung eine Spannungsmeßeinrichtung eine Einrichtung zur Bestimmung eines Korrekturwertes und einen Addierer auf. Jede Spannungsmeßeinrichtung ist eingangsseitig mit einem Hauptanschluß und einem Bezugsanschluß eines niedersperrenden Halbleiterschalters einer Kaskodenschaltung und ausgangsseitig mit einem Eingang der zugehörigen Einrichtung zur Bestimmung eines Korrekturwertes verknüpft. Ausgangsseitig ist jede Einrichtung mit einem ersten Eingang eines Addierers verknüpft, an dessen zweiten Eingang ein Steuersignal eines korrespondierenden niedersperrenden Halbleiterschalters ansteht. Da man die Ausgangsspannung des niedersperrenden Halbleiterschalters einer jeden Kaskodenschaltung ermittelt, werden hinsichtlich der Spannungsfestigkeit keine besonderen Anforderungen an die Spannungsmeßeinrichtung gestellt, obwohl an der Kaskodenschaltung eine Sperrspannung mit einem Wert von > 600 V anliegt. Somit erhält man mit einfachen Mitteln eine Vorrichtung, mit der aktiv die Stromaufteilung mehrerer parallel geschalteter Kaskodenschaltungen symmetriert werden kann.

Bei einem vorteilhaften Verfahren werden die ermittelten Korrekturwerte nicht zur Veränderung der Steuersignale der niedersperrenden Halbleiterschalter der parallel geschalteten Kaskodenschaltungen verwendet, sondern jeweils einer steuerbaren Entkopplungseinrichtung zugeführt. Jeder dieser steuerbaren Entkopplungseinrichtung verknüpft einen Steueranschluß eines hochsperrenden Halbleiterschalters mit einem Bezugsanschluß seines zugeordneten niedersperrenden Halbleiterschalters. Durch die ermittelten Korrekturwerte werden die Entkopplungen zwischen den hoch- und niedersperrenden Halbleiterschaltern der parallel geschalteten Kaskodenschaltungen derart abgeändert, daß die ermittelten Ausgangsspannungen der niedersperrenden Halbleiterschalter sich angleichen, wodurch die Stromaufteilung aktiv symmetriert wird. Gegenüber dem zuvor genannten Verfahren fällt eine Spannungserhöhung am hochsperrenden Halbleiterschalter und nicht mehr am niedersperrenden Halbleiterschalter einer Kaskodenschaltung ab.

In den Unteransprüchen 3 bis 6 sind verschiedene Verfahren zur Ermittlung von Korrekturwerten näher angegeben.

In den Unteransprüchen 9 bis 12 sind verschiedene Ausführungsformen der.Einrichtung zur Bestimmung eines Korrekturwertes entnehmbar.

In den Unteransprüchen 13 bis 16 sind jeweils Ausführungsformen für den nieder- und hochsperrenden Halbleiterschalter einer Kaskodenschaltung angegeben.

Zur näheren Erläuterung der Erfindung wird auf die Zeichnung Bezug genommen, in der mehrere Ausführungsformen der erfindungsgemäßen Vorrichtung zur Symmetrierung der Verlustleistung mehrerer elektrisch parallel geschalteter Kaskodenschaltungen schematisch veranschaulicht sind.
- FIG 1: zeigt eine Parallelschaltung zweier MOSFET, wobei in der
- FIG 2: die Ausgangskennlinien der MOSFET nach FIG 1 dargestellt sind und in der
- FIG 3: die Änderung der Ausgangskennlinie eines MOSFET in Abhängigkeit der Steuerspannung veranschaulicht ist, die
- FIG 4: zeigt eine Ausführungsform der erfindungsgemäßen Vorrichtung, wobei in den
- FIG 5 und 6: jeweils eine vorteilhafte Ausführungsform der Vorrichtung nach FIG 4 veranschaulicht sind und in der
- FIG 7: ist eine zweite Ausführungsform der erfindungsgemäßen Vorrichtung dargestellt, wobei die
- FIG 8 und 9: jeweils eine vorteilhafte Ausführungsform der Vorrichtung nach FIG 7 zeigen.

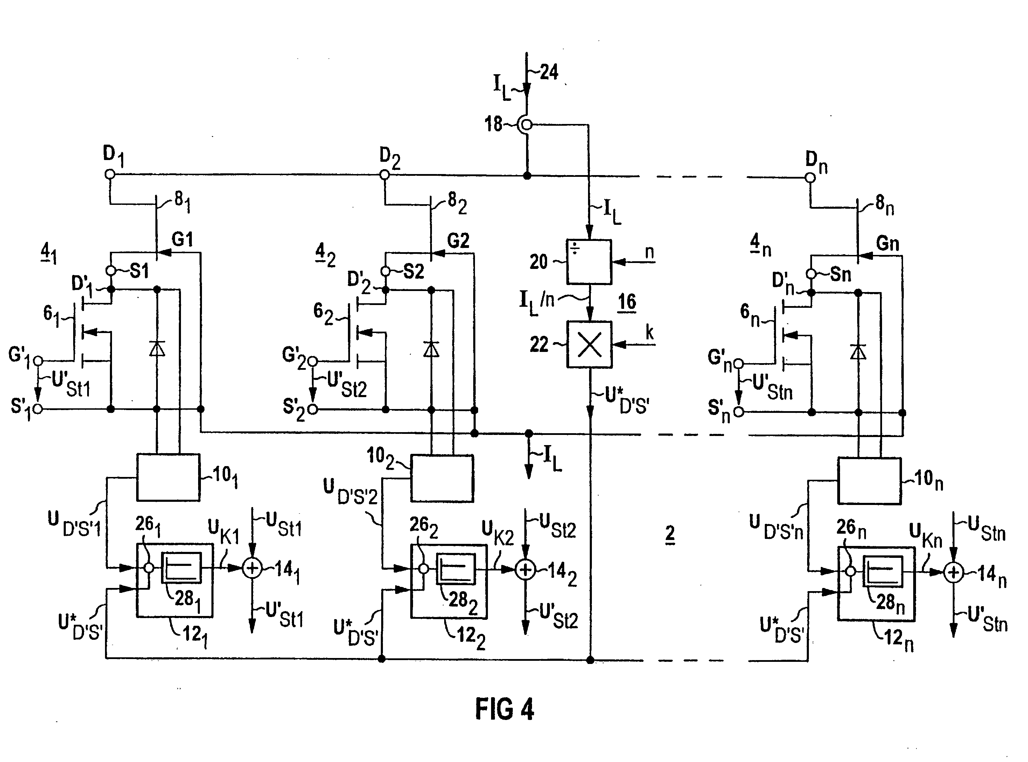

Die FIG 4 zeigt eine erste Ausführungsform einer erfindungsgemäßen Vorrichtung 2 zur Symmetrierung der Verlustleistung mehrerer Kaskodenschaltungen 4₁,4₂....,4ₙ Jede Kaskodenschaltung 4₁,4₂,...,4ₙ weist einen niedersperrenden Halbleiterschalter 6₁,6₂,...,6ₙ aus Silizium und einen hochsperrenden Halbleiterschalter 8₁,8₂,...,8ₙ aus Siliziumkarbid auf. In der dargestellten Ausführungsform ist als niedersperrender Halbleiterschalter 6₁,6₂,...,6ₙ ein n-Kanal-MOSFET, insbesondere ein Niedervolt-Leistungs-MOSFET, und als hochsperrender Halbleiterschalter 8₁,8₂,...,8ₙ einen Sperrschicht-FET, auch als Junction-Field-Effect-Transistor (JFET) bezeichnet, vorgesehen. Somit sind in dieser Darstellung mehrere aus dem Deutschen Patent 196 10 135 bekannte Kaskodenschaltungen 4₁,4₂,...,4ₙ dargestellt, die elektrisch parallel geschaltet sind. Dazu sind die Hauptanschlüsse D₁,D₂,...Dₙ der hochsperrenden Halbleiterschalter 8₁,8₂,...,8ₙ und die Bezugsanschlüsse S'₁,S'₂,...,S'ₙ der parallel geschalteten Kaskodenschaltungen 4₁,4₂,...,4ₙ jeweils elektrisch leitend verbunden. Jede Kaskodenschaltung 4₁,4₂,...,4ₙ wird mittels einem Steuersignal U_{St1},U_{St2},...,U_{Stn} angesteuert, wobei diese Steuerspannung U_{St1},U_{St2},...,U_{Stn} an einen Steueranschluß G'₁,G'₂,...G'ₙ des niedersperrenden Halbleiterschalters 6₁,6₂,...,6ₙ angelegt wird. Der Steueranschluß G1,G2,...,Gn des hochsperrenden Halbleiterschalters 8₁,8₂,...,8ₙ ist mit dem Bezugsanschluß S'₁,S'₂,...,S'ₙ der Kaskodenschaltung 4₁,4₂,...,4ₙ elektrisch leitend verbunden.

Wie bereits erwähnt und in der FIG 4 dargestellt, weist jede Kaskodenschaltung 4₁,4₂,...,4ₙ einen MOSFET aus Silizium als niedersperrenden Halbleiterschalter 6₁,6₂,...,6ₙ und einen JFET aus Siliziumkarbid als hochsperrenden Halbleiterschalter 8₁,8₂,...,8ₙ auf. Deshalb wird die Kaskodenschaltung 4₁,4₂,...,4ₙ in dieser Ausführungsform auch als Hybrid-Leistungs-MOSFET bezeichnet. Als Halbleiterschalter 6₁,6₂,...,6ₙ aus Silizium und als Halbleiterschalter 8₁,8₂,...,8ₙ aus Siliziumkarbid kann jeweils ein Insulated-Gate-Bipolar-Transistor oder jeweils ein Bipolartransistor vorgesehen sein. Es ist auch möglich, das als Halbleiterschalter 6₁,6₂,...,6ₙ und 8₁,8₂,...,8ₙ jeweils ein MOSFET vorgesehen sind.

Die Vorrichtung 2 zur Symmetrierung der Verlustleistung mehrerer elektrisch parallel geschalteter Kaskodenschaltungen 4₁,4₂,...,4ₙ weist für jede Kaskodenschaltung 4₁,4₂,...,4ₙ eine Spannungsmeßeinrichtung 10₁,10₂,...,10ₙ, eine Einrichtung 12₁,12₂,...,12ₙ zur Bestimmung eines Korrekturwertes U_{K1},U_{K2},...,U_{Kn} und einen Addierer 14₁,14₂,...,14ₙ auf. Außerdem weist diese Vorrichtung einen Sollwertbildner 6 auf. Jede Spannungsmeßeinrichtung 10₁,10₂,...,10ₙ ist eingangsseitig mit einem Hauptanschluß D'₁,D'₂,...,D'ₙ und einem Bezugsanschluß S'₁,S'₂,...,S'ₙ eines zugehörigen niedersperrenden Halbleiterschalters 6₁,6₂,...,6ₙ verknüpft. Ausgangsseitig ist jede Spannungsmeßeinrichtung 10₁,10₂,...,10ₙ mit einem Istwert-Eingang der Einrichtung 12₁,12₂,...,12ₙ verbunden. Ausgangsseitig ist diese Einrichtung 12₁,12₂,...,12ₙ mit einem ersten Eingang eines zugehörigen Addierers 14₁,14₂,...,14ₙ verknüpft, an dessen zweiten Eingang ein Steuersignal U_{St1},U_{St2},...,U_{Stn} ansteht.

Der Sollwert-Bildner 16 weist eine Strommeßeinrichtung 18, einen Dividierer 20 und einen Multiplizierer 22. Die Strommeßeinrichtung 18 ist in der Zuleitung 24 der Parallelschaltung der n Kaskodenschaltungen 4₁,4₂,...,4ₙ angeordnet und ausgangsseitig mit einem ersten Eingang des Dividierers 20 verknüpft. Am zweiten Eingang dieses Dividierers 20 steht eine Anzahl n an. Ausgangsseitig ist dieser Dividierer 20 mit einem Eingang des Multiplizierers 22 verbunden, an dessen zweiten Eingang ein Proportionalitätsfaktor k ansteht. Der Ausgang dieses Multiplizierers 22 ist jeweils mit einem Sollwert-Eingang der Einrichtung 12₁,12₂,...,12ₙ zur Bestimmung eines Korrekturwertes U_{K1},U_{K2},...,U_{Kn} verknüpft. Mit Hilfe des Dividierers 20 erhält man aus einen gemessenen Laststrom I_{L} einen n-ten Teil dieses Stromes. Dieser n-te Teil des Laststromes I_{L} fließt bei einer symmetrischen Stromaufteilung durch die n Kaskodenschaltungen 4₁,4₂,...,4ₙ. Dieser n-te Teil des Laststromes I_{L} wird mit Hilfe des Multiplizierers 22 und eines Proportionalitätsfaktors k in einem Spannungswert umgerechnet, der als Sollwert U*_{D'S'} jeder Einrichtung 12₁,12₂,...,12ₙ der Vorrichtung 2 zugeführt wird.

Jede Einrichtung 12₁,12₂,...,12ₙ zur Bestimmung eines Korrekturwertes U_{K1},U_{K2},...,U_{Kn} weist einen Regelkreis auf, der aus einen Vergleicher 26₁,26₂,...,26ₙ und einem Regler 28₁,28₂,...,28ₙ besteht. Die Eingänge des Vergleichers 26₁,26₂,...,26ₙ sind mit dem Istwert- und dem Sollwert-Eingang der Einrichtung 12₁,12₂,...,12ₙ verbunden. Der Ausgang des Reglers 28₁,28₂,...,28ₙ ist mit dem Ausgang der Einrichtung 12₁,12₂,...,12ₙ verknüpft. In der Darstellung ist als Regler 28₁,28₂,...,28ₙ ein P-Regler vorgesehen. Als Regler 28₁,28₂,...,28ₙ kann auch ein PI-Regler vorgesehen sein.

Jeder ermittelte Korrekturwert U_{K1},U_{K2},...,U_{Kn} wird mittels eines Addierers 14₁,14₂,...,14ₙ einem korrespondierenden Steuersignal U_{St1},U_{St2},...,U_{Stn} überlagert. An jedem Ausgang der n Addierer 14₁,14₂,...,14ₙ steht ein korrigiertes Steuersignal U'_{St1},U'_{St2},...,U'_{Stn} an, das den niedersperrenden Halbleiterschalters 6₁,6₂,...,6ₙ der korrespondierenden Kaskodenschaltung 4₁,4₂,...,4ₙ derart ansteuert, daß in Abhängigkeit der Unsymmetrie die Ausgangsspannung U_{D'S'} des niedersperrenden Halbleiterschalters 6₁,6₂,...,6ₙ derart erhöht oder erniedrigt wird, daß die Unsymmetrie aufgehoben wird. Das heißt, jede Ausgangsspannung U_{D'S'} der niedersperrenden Halbleiterschalter 6₁,6₂,...,6ₙ der n Kaskodenschaltungen 4₁,4₂,...,4ₙ werden auf den vorbestimmten Sollwert U*_{D'S'} geregelt.

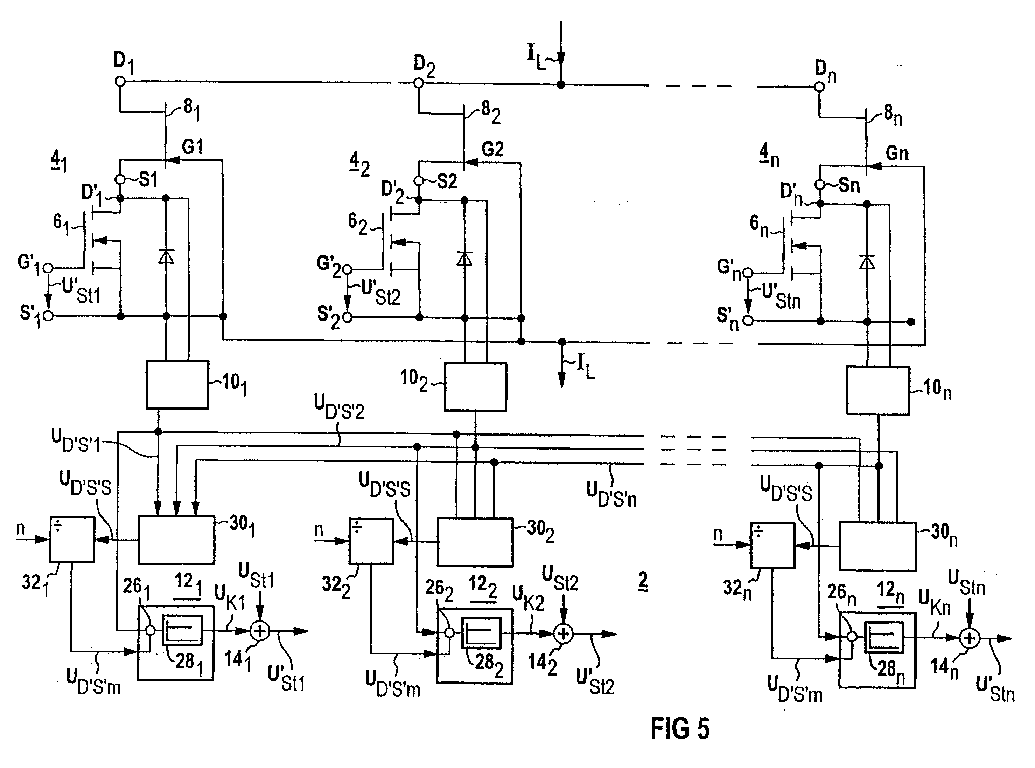

In der FIG 5 ist eine vorteilhafte Ausführungsform der ersten Ausführungsform der Vorrichtung 2 zur Symmetrierung der Verlustleistungen von mehreren elektrisch parallel geschalteten Kaskodenschaltungen 4₁,4₂,...,4ₙ nach FIG 4 näher dargestellt. Diese Ausführungsform unterscheidet sich von der Ausführungsform gemäß FIG 4 dadurch, daß kein Sollwert-Bildner 16 verwendet wird. Dafür weist jede Einrichtung 12₁,12₂,...,12ₙ eine Summeneinrichtung 30₁,30₂,...,30ₙ auf, die n Eingänge aufweist. Jeder Eingang dieser Summeneinrichtung 30₁,30₂,...,30ₙ bildet einen Istwert-Eingang einer Einrichtung 12₁,12₂,...,12ₙ, die mit einem Ausgang der n Spannungsmeßeinrichtungen 10₁,10₂,...,10ₙ verknüpft sind. Ausgangsseitig ist jede Summeneinrichtung 30₁,30₂,...,30ₙ mit einem Dividierer 32₁,32₂,...32ₙ verknüpft, an dessen zweiten Eingang eine Anzahl n ansteht. Ausgangsseitig ist jeder Dividierer 32₁,32₂,...,32ₙ mit einem Sollwert-Eingang eines zugehörigen Regelkreises verbunden, dessen Ausgang einen Ausgang einer Einrichtung 12₁,12₂,...,12ₙ zur Bestimmung eines Korrekturwertes U_{K1},U_{K2},...,U_{Kn} bildet. Jede Summeneinrichtung 30₁,30₂,...,30ₙ und jeder Dividierer 32₁,32₂,...,32ₙ bilden jeweils einen Mittelwertbildner.

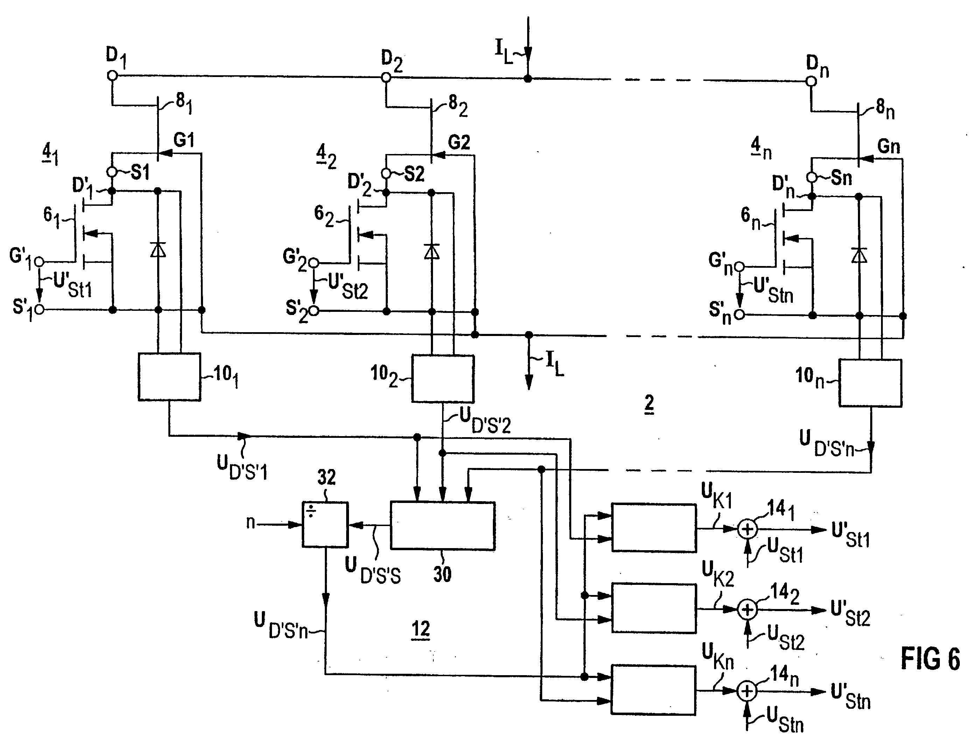

Eine weitere vorteilhafte Ausführungsform der Vorrichtung 2 zur Symmetrierung gemäß FIG 4 ist in der FIG 6 näher dargestellt. Gegenüber der Ausführungsform gemäß FIG 5 weist die Vorrichtung 2 dieser Ausführungsform anstelle von n Mittelwertbildnern, bestehend jeweils aus einer Summeneinrichtung 30₁,30₂,...,30ₙ mit nachgeschalteten Dividierer 32₁,32₂,...,32ₙ, nur einen Mittelwertbildner auf. Ansonsten ist diese Ausführungsform identisch mit der Ausführungsform gemäß FIG 5.

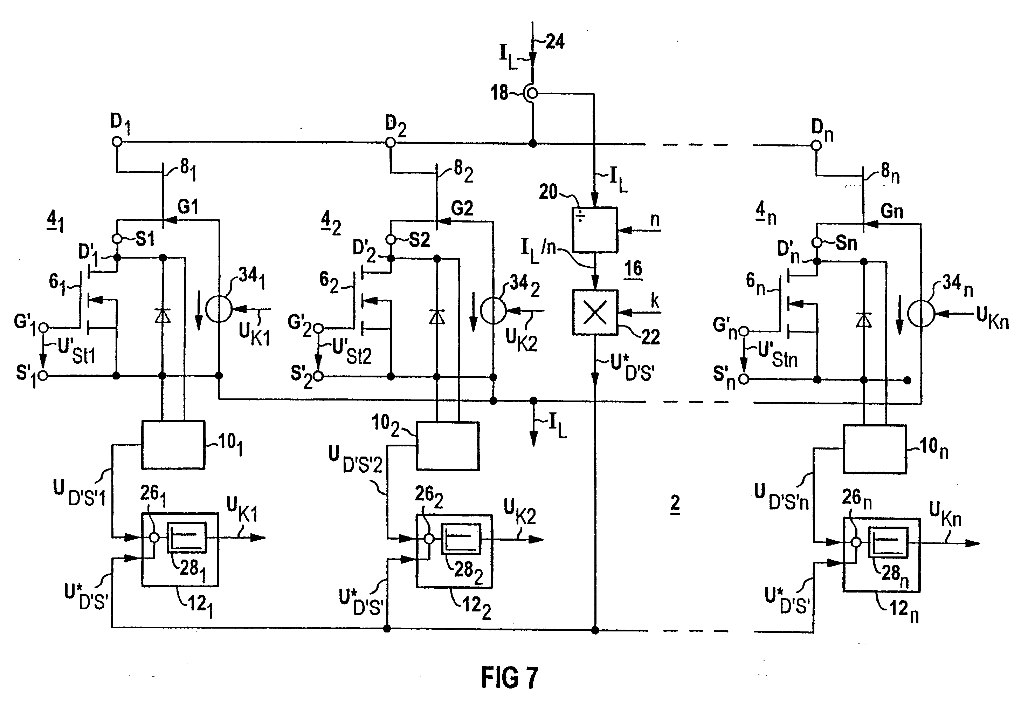

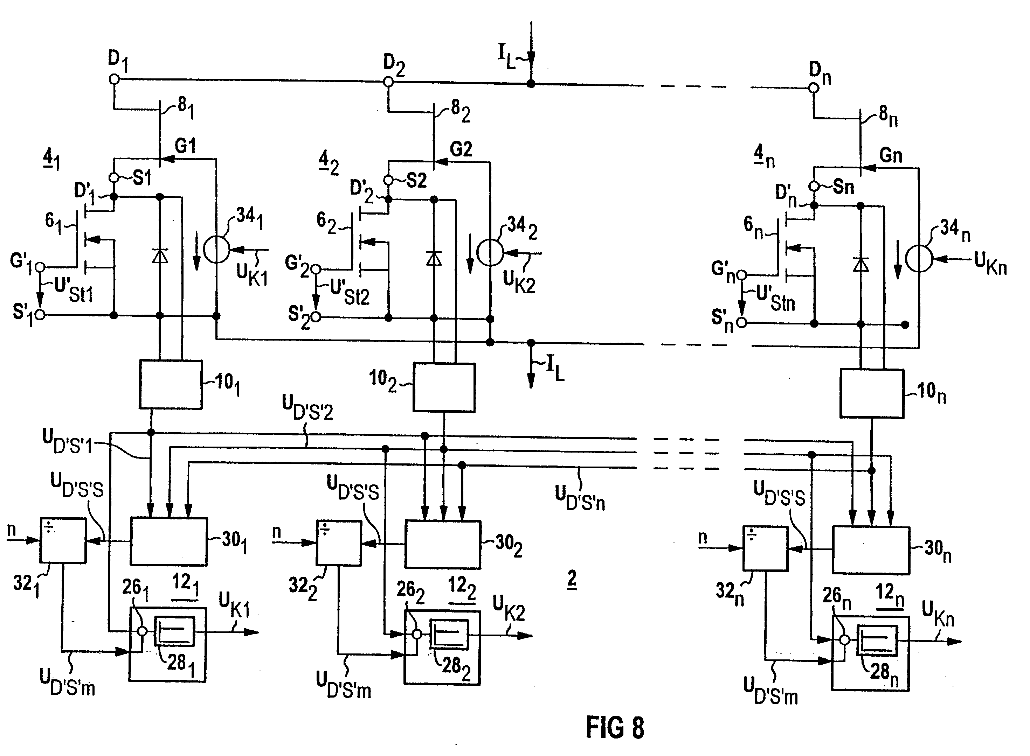

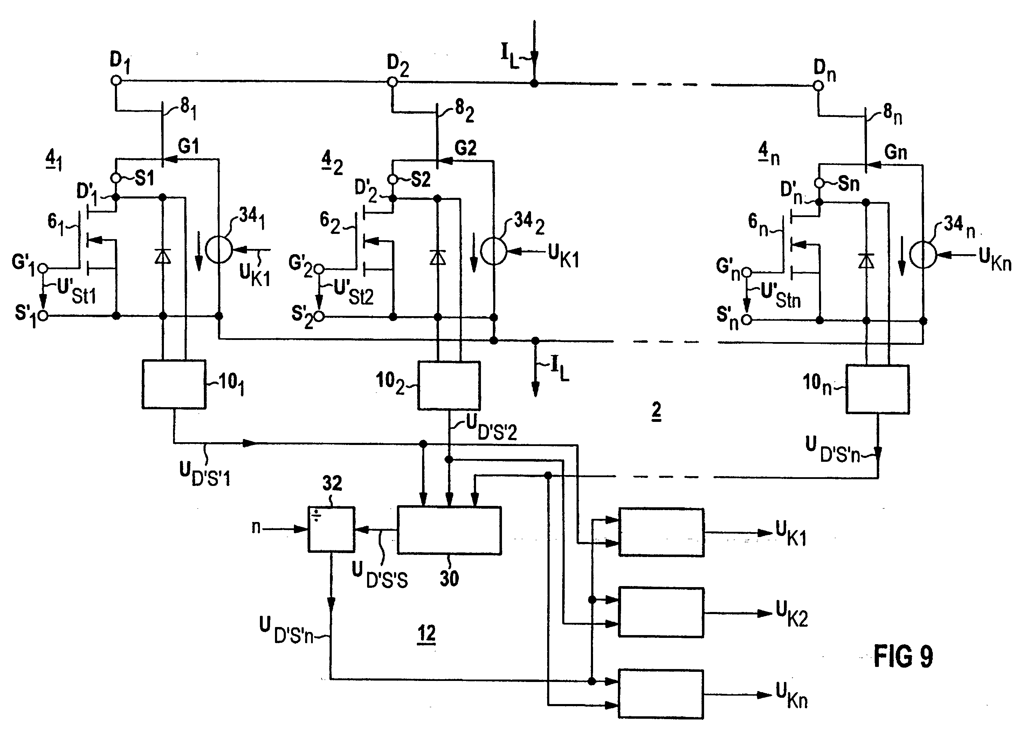

Die FIG 7 bis 9 zeigen die Ausführungsformen der Vorrichtung 2 zur Symmetrierung der Verlustleistungen von mehreren elektrisch parallel geschalteten Kaskodenschaltung 4₁,4₂,...,4ₙ gemäß den FIG 4 bis 6, wobei jede Kaskodenschaltung 4₁,4₂,...,4ₙ eine steuerbare Entkopplungseinrichtung 34₁,34₂,...,34ₙ aufweist. Diese steuerbare Entkopplungseinrichtung 34₁,34₂,...,34ₙ verbindet den Steueranschluß G1,G2,...,Gn des hochsperrenden Halbleiterschalters 8₁,8₂,...,8ₙ mit dem Bezugsanschluß S'₁,S'₂,...,S'ₙ des zugehörigen niedersperrenden Halbleiterschalters 6₁,6₂,...,6ₙ. Als steuerbare Entkopplungseinrichtung 34₁,34₂,...,34ₙ ist eine steuerbare Spannungsquelle vorgesehen. Wird elektrisch in Reihe zur steuerbaren Spannungsquelle ein Widerstand geschaltet, so generiert diese gesteuerte Spannungsquelle in Abhängigkeit des Widerstandes einen Stromwert. Diese Ausführungsform wird benötigt bei stromgesteuerten Halbleiterschaltern 8₁,8₂,...,8ₙ der Kaskodenschaltung 4₁,4₂,...,4ₙ.

Die Ausführungsform der Vorrichtung 2 gemäß der FIG 7 bis 9 unterscheidet sich bedingt durch die Verwendung der gesteuerten Entkopplungseinrichtung 34₁,34₂,...,34ₙ von den Ausführungsformen der Vorrichtung 2 gemäß der FIG 4 bis 6 dadurch, daß keine Addierer 14₁,14₂,...,14ₙ mehr benötigt werden. Die von der bzw. den Einrichtungen 12 bzw. 12₁,12₂,...,12ₙ generierten Korrekturwerten U_{K1},U_{K2},...,U_{Kn} werden den zugehörigen gesteuerten Entkopplungseinrichtungen 34₁,34₂,...,34ₙ zugeführt. Ansonsten entsprechen die Vorrichtungen 2 gemäß den FIG 7 bis 9, den Vorrichtungen 2 gemäß den FIG 4 bis 6. Durch die Verwendung der n gesteuerten Entkopplungseinrichtungen 34₁,34₂,...,34ₙ bei einer Parallelschaltung von n Kaskodenschaltungen 4₁,4₂,...,4ₙ fällt eine erhöhte Durchlaßspannung jeweils am hochsperrenden Halbleiterschalter 8₁,8₂,...,8ₙ der Kaskodenschaltungen 4₁,4₂,...,₄ₙ ab.

## Patentansprüche

1. Verfahren zur Symmetrierung der Verlustleistung wenigstens zweier elektrisch parallel geschalteter Kaskodenschaltungen (4₁,4₂,....,4ₙ), die jeweils einen niedersperrenden Halbleiterschalter (6₁,6₂,...,6ₙ) aus Silizium und einen hochsperrenden Halbleiterschalter (8₁,8₂,...,8ₙ) aus Siliziumkarbid aufweisen, wobei eine Ausgangsspannung (U_{D'S'1}, U_{D'S'2,}..., U_{D'S'n}) eines jeden niedersperrenden Halbleiterschalters (6₁,6₂,...,6ₙ) der parallel geschalteten Kaskodenschaltungen (4₁,4₂,...,4ₙ) erfaßt wird, wobei in Abhängigkeit dieser ermittelten Ausgangsspannungen ((U_{D'S'1}, U_{D'S'2},...,U_{D'S'n}) Korrekturwerte (U_{K1},U_{K2},...,U_{Kn}) bestimmt werden, und wobei diese Korrekturwerte (U_{K1},U_{K2},...,U_{Kn}) korrespondierenden Steuersignalen (U_{St1},U_{St2},...,U_{Stn}) der niedersperrenden Halbleiterschalter (6₁,6₂,...,6ₙ) der parallel geschalteten Kaskodenschaltungen (4₁,4₂,...,4ₙ) überlagert werden.

2. Verfahren zur Symmetrierung der Verlustleistung wenigstens zweier elektrisch parallel geschalteter Kaskodenschaltungen (4₁,4₂,...,4ₙ), die jeweils einen niedersperrenden Halbleiterschalter (6₁,6₂,...,6ₙ) aus Silizium und einen hochsperrenden Halbleiterschalter (8₁, 8₂, ..., 8ₙ) aus Siliziumkarbid aufweisen, wobei jeweils ein Steueranschluß (G1,...,Gn) des hochsperrenden Halbleiterschalters (8₁,8₂,...,8ₙ) mittels einer steuerbaren Entkopplungseinrichtung (34₁,34₂,...,34ₙ) mit einem Bezugsanschluß (S'₁,...,S'ₙ) seines korrespondierenden niedersperrenden Halbleiterschalters (6₁,6₂,...,6ₙ) verknüpft ist, wobei eine Ausgangsspannung (U_{D'S'1},...,U_{D'S'n}) eines jeden niedersperrenden Halbleiterschalters (6₁,6₂,...,6ₙ) der parallel geschalteten Kaskodenschaltungen (4₁,4₂,...,4ₙ) erfaßt wird wobei in Abhängigkeit dieser ermittelten Ausgangsspannungen (U_{D'S'1},...,U_{D'S'n}) Korrekturwerte (U_{K1},U_{K2},...,U_{Kn}) bestimmt werden, und wobei diese Korrekturwerte (U_{D'S'1},...,U_{D'S'n}) korrespondierenden steuerbaren Entkopplungseinrichtungen (34₁,34₂,...,34ₙ) zugeführt werden.

3. Verfahren nach Anspruch 1 oder 2, wobei die ermittelten Ausgangsspannungen (U_{D'S'1},...,U_{D'S'n}) jeweils mit einem vorbestimmten Ausgangsspannungsmittelwert (D_{D'S'm}) verglichen werden und wobei aus jeder ermittelten Regelabweichung ein Korrekturwert (U_{K1},U_{K2},...,U_{Kn}) bestimmt wird.

4. Verfahren nach Anspruch 1 oder 2, wobei jede ermittelte Ausgangsspannung (U_{D'S'1},...,U_{D'S'n}) mit einem vorbestimmten Sollwert (U*_{D'S'}) verglichen wird und wobei aus jeder ermittelten Regeldifferenz ein Korrekturwert (U_{D'S'1},...,U_{D'S'n}) bestimmt wird.

5. Verfahren nach Anspruch 3, wobei zur Bestimmung eines Ausgangsspannungsmittelwertes (U_{D'S'm}) die ermittelten Ausgangsspannungen (U_{D'S'1},...,U_{D'S'n}) aufaddiert werden und der Summenwerte durch die Anzahl der ermittelten Ausgangsspannungen (U_{D'S'1},...,U_{D'S'n}) geteilt wird.

6. Verfahren nach Anspruch 4, wobei zur Bestimmung eines Sollwertes (U*_{D'S'}) ein Gesamtstrom (I_{L}) der parallel geschalteten Kaskodenschaltungen (4₁,4₂,...,4ₙ) gemessen wird, und diese anschließend durch die Anzahl (n) der parallel geschalteten Kaskodenschaltungen (4₁,4₂,...,4ₙ) geteilt und mit einem Proportionalitätsfaktor (k) multipliziert wird.

7. Vorrichtung (2) zur Symmetrierung der Verlustleistung wenigstens zweier elektrisch parallel geschalteten Kaskodenschaltungen (4₁,4₂,...,4ₙ), die jeweils einen niedersperrenden Halbleiterschalter (6₁,6₂,...,6ₙ) aus Silizium und einen hochsperrenden Halbleiterschalter (8₁,8₂,...,8ₙ) aus Siliziumkarbid aufweisen, wobei diese Vorrichtung (2) für jede Kaskodenschaltung (4₁,4₂,...,4ₙ) eine Spannungsmeßeinrichtung (10₁,10₂,...,10ₙ), eine Einrichtung (12₁,12₂,...,12ₙ) zur Bestimmung eines Korrekturwertes (U_{K1},U_{K2},...,U_{Kn}) und einen Addierer (14₁,14₂,...,14ₙ) aufweist, wobei jede Spannungsmeßeinrichtung (10₁,10₂,...,10ₙ) eingangsseitig mit einem Hauptanschluß (D') und einem Bezugsanschluß (S') eines niedersperrenden Halbleiterschalters (6₁,6₂,...,6ₙ) und ausgangsseitig mit einem Eingang einer korrespondierenden Einrichtung (12₁,12₂,...,12ₙ) verknüpft sind, und wobei jede Einrichtung (12₁,12₂,...,12ₙ) ausgangsseitig mit einem Eingang eines korrespondierenden Addierers (14₁,14₂,...,14ₙ) verbunden ist, an dessen zweiten Eingang ein Steuersignal (U_{St1},U_{St2},...,U_{Stn}) ansteht.

8. Vorrichtung zur Symmetrierung der Verlustleistung wenigstens zweier elektrisch parallel geschalteter Kaskodenschaltungen (4₁,4₂,...,4ₙ), die jeweils einen niedersperrenden Halbleiterschalter (6₁,6₂,...,6ₙ) aus Silizium und einen hochsperrenden Halbleiterschalter (8₁,8₂,...,8ₙ) aus Siliziumkarbid aufweisen, wobei jeweils ein Steueranschluß (G1,...,Gn) der hochsperrenden Halbleiterschalter (8₁,8₂,...,8ₙ) mittels einer steuerbaren Entkopplungseinrichtung (34₁,34₂,...,34ₙ) mit einem Bezugsanschluß (S'₁,...,S'ₙ) seines korrespondierenden niedersperrenden Halbleiterschalters (6₁,6₂,...,6ₙ) verknüpft ist, wobei diese Vorrichtung (2) für jede Kaskodenschaltung (4₁,4₂,...,4ₙ) eine Spannungsmeßeinrichtung (10₁,10₂,...,10ₙ) und eine Einrichtung ((12₁,12₂,...,12ₙ) zur Bestimmung eines Korrekturwertes (U_{K1},U_{K2}, ..., U_{Kn}) aufweist, wobei jede Spannungsmeßeinrichtung (10₁,10₂,...,10ₙ) eingangsseitig mit einem Hauptanschluß (D'₁,D'₂, ..., D'ₙ) und mit einem Bezugsanschluß (S'₁,S'₂,...,S'ₙ) eines niedersperrenden Halbleiterschalters (6₁,6₂,...,6ₙ) und ausgangsseitig mit einem Eingang einer korrespondierenden Einrichtung (12₁,12₂,...,12ₙ) verknüpft sind, und wobei jede Einrichtung (12₁,12₂,...,12ₙ) ausgangsseitig mit einem Steuereingang einer korrespondierenden steuerbaren Entkopplungseinrichtung (34₁,34₂,...,34ₙ) verbunden ist.

9. Vorrichtung (2) nach Anspruch 7 oder 8, wobei jede Einrichtung (12₁,12₂,...,12ₙ) zur Bestimmung eines Korrekturwertes (U_{K1},U_{K2},...,U_{Kn}) einen Regelkreis aufweist, der eingangsseitig einerseits mit einem Ausgang eines Sollwertbildner (16) und andererseits mit einem Ausgang einer korrespondierenden Spannungsmeßeinrichtung (10₁,10₂,...,10ₙ) verknüpft ist, und wobei der Regelkreis einen Vergleicher (26₁,26₂,...,26ₙ) mit nachgeschaltetem Regler (28₁,28₂,...,28ₙ) aufweist.

10. Vorrichtung (2) nach Anspruch 7 oder 8, wobei jede Einrichtung (12₁,12₂,...,12ₙ) zur Bestimmung eines Korrekturwertes (U_{K1},U_{K2},...,U_{Kn}) eingangsseitig eine Summeneinrichtung (30₁,30₂,...,30ₙ) mit mehreren Eingängen und ausgangsseitig einen Regelkreis aufweist, der eingangsseitig einerseits mittels eines Dividierers (32₁,32₂,...,32ₙ) mit dem Ausgang der Summeneinrichtung (30₁,30₂,...,30ₙ) und andererseits mit einem Eingang der Summeneinrichtung (30₁,30₂,...,30ₙ) verknüpft ist, wobei am zweiten Eingang des Dividierers (32₁,32₂,...,32ₙ) die Anzahl (n) der parallel geschalteten Kaskodenschaltungen (4₁,4₂,...,4ₙ) ansteht, und wobei der Regelkreis einen Vergleicher (26₁,26₂,...,26ₙ) mit nachgeschalteten Reglern (38₁,38₂,...,38ₙ) aufweist.

11. Vorrichtung (2) nach Anspruch 7 oder 8, wobei eine Einrichtung (12) zur Bestimmung mehrerer Korrekturwerte (U_{K}1,U_{K2},...,U_{Kn}) eingangsseitig eine Summeneinrichtung (30) mit mehreren Eingängen und ausgangsseitig mehrere Regelkreise aufweist, wobei der Summeneinrichtung (30) ein Dividierer (32) nachgeschaltet ist, der ausgangsseitig jeweils mit einem Eingang der Regelkreise verbunden ist, wobei ein zweiter Eingang der mehreren Regelkreise jeweils mit einem Eingang der Summeneinrichtung (30) verknüpft ist, und wobei jeder Regelkreis einen Vergleicher (26₁,26₂,...,26ₙ) mit nachgeschalteten Regler (28₁,28₂,...,28ₙ) aufweist.

12. Vorrichtung (2) nach Anspruch 9, wobei ein Sollwertbildner (16) eine Strommeßeinrichtung (18), einen Dividierer (20) und einen Multiplizierer (22) aufweist, wobei der Dividierer (20) den Ausgang der Strommeßeinrichtung (18) mit einem Eingang des Multiplizierers (22) verknüpft, und wobei am zweiten Eingang des Dividierers (20) die Anzahl (n) der parallel geschalteten Kaskodenschaltungen (4₁, 4₂,...,4ₙ) und am zweiten Eingang des Multiplizierers (22) ein Proportionalitätsfaktor (k) anstehen.

13. Vorrichtung (2) nach einem der Ansprüche 7 bis 12, wobei als niedersperrender Halbleiterschalter (6₁,6₂,...,6ₙ) ein MOSFET vorgesehen ist.

14. Vorrichtung (2) nach einem der Ansprüche 7 bis 12, wobei als hochsperrender Halbleiterschalter (8₁,8₂,...,8ₙ) ein Sperrschicht-FET vorgesehen ist.

15. Vorrichtung (2) nach einem der Ansprüche 7 bis 12, wobei als niedersperrender und als hochsperrender Halbleiterschalter (6₁,6₂,...,6ₙ;8₁,8₂,...,8ₙ) jeweils ein Bipolartransistor vorgesehen sind.

16. Vorrichtung (2) nach einem der Ansprüche 7 bis 12, wobei als niedersperrender und als hochsperrender Halbleiterschalter (6₁,6₂,...,6ₙ;8₁,8₂,...,8ₙ) jeweils ein Insulated-Gate-Bipolar-Transistor vorgesehen sind.

## Revendications

1. Procédé pour l'équilibrage de la perte de puissance d'au moins deux circuits cascodes (4₁, 4₂, ..., 4ₙ) branchés en parallèle et comportant respectivement un commutateur semi-conducteur à blocage bas (6₁, 6₂, ..., 6ₙ) en silicium et un commutateur semi-conducteur à blocage haut (8₁, 8₂, ..., 8ₙ) en carbure de silicium, dans lequel on détecte une tension de sortie (U_{D'S'1}, U_{D'S'2}, ..., U_{D'S'n}) de chaque commutateur semi-conducteur à blocage bas (6₁, 6₂, ..., 6ₙ) des circuits cascodes (4₁, 4₂, ..., 4ₙ) branchés en parallèle, dans lequel on détermine des valeurs de correction (U_{K1}, U_{K2}, ..., U_{Kn}) en fonction de ces tensions de sortie déterminées (U_{D'S'1}, U_{D'S'2}, ..., U_{D'S'n}) et dans lequel on superpose ces valeurs de correction (U_{K1}, U_{K2}, ..., U_{Kn}) à des signaux de commande correspondants (U_{St1}, U_{St2}, ..., U_{Stn}) des commutateurs semi-conducteurs à blocage bas (6₁, 6₂, ..., 6ₙ) des circuits cascodes (4₁, 4₂, ..., 4ₙ) branchés en parallèle.

2. Procédé pour l'équilibrage de la perte de puissance d'au moins deux circuits cascodes (4₁, 4₂, ..., 4ₙ) branchés en parallèle et comportant respectivement un commutateur semi-conducteur à blocage bas (6₁, 6₂, ..., 6ₙ) en silicium et un commutateur semi-conducteur à blocage haut (8₁, 8₂, ..., 8ₙ) en carbure de silicium, dans lequel, à chaque fois, une borne de commande (G1, ..., Gn) du commutateur semi-conducteur à blocage haut (8₁, 8₂, ..., 8ₙ) est reliée au moyen de son dispositif de découplage commandable (34₁, 34₂, ..., 34ₙ) à une borne de référence (S'₁, ..., S'ₙ) de son commutateur semi-conducteur à blocage bas (6₁, 6₂, ..., 6ₙ) correspondant, dans lequel on détecte une tension de sortie (U_{D'S'1}, ..., U_{D'S'n}) de chaque commutateur semi-conducteur à blocage bas (6₁, 6₂, ..., 6ₙ) des circuits cascodes (4₁, 4₂, ..., 4ₙ) branchés en parallèle, dans lequel on détermine des valeurs de correction (U_{K1}, U_{K2}, ..., U_{Kn}) en fonction de ces tensions de sortie déterminées (U_{D'S'1}, ..., U_{D'S'n}) et dans lequel on envoie ces valeurs de correction (U_{K1}, U_{K2}, ..., U_{Kn}) à des dispositifs de découplage commandables (34₁, 34₂, ..., 34ₙ) correspondants.

3. Procédé selon la revendication 1 ou 2, dans lequel on compare les tensions de sortie déterminées (U_{D'S'1}, ..., U_{D'S'n}) à chaque fois à une valeur moyenne de tension de sortie prédéterminée (D_{D'S'm}) et dans lequel on détermine à partir de chaque différence de régulation déterminée une valeur de correction (U_{K1}, U_{K2}, ..., U_{Kn}).

4. Procédé selon la revendication 1 ou 2, dans lequel on compare chaque tension de sortie déterminée (U_{D'S'1}, ..., U_{D'S'n}) à une valeur de consigne prédéterminée (U*_{D'S'}) et dans lequel on détermine à partir de chaque différence de régulation déterminée une valeur de correction (U_{K1}, U_{K2},...,U_{Kn}).

5. Procédé selon la revendication 3, dans lequel, pour la détermination d'une valeur moyenne de tension de sortie prédéterminée (D_{D'S'm}), on additionne les tensions de sortie déterminées (U_{D'S'1}, ..., U_{D'S'n}) et on divise la valeur cumulée par le nombre des tensions de sortie déterminées (U_{D'S'1}, ..., U_{D'S'n}).

6. Procédé selon la revendication 4, dans lequel, pour la détermination d'une valeur de consigne (U*_{D'S'}), on mesure un courant total (I_{L}) des circuits cascodes (4₁, 4₂, ..., 4ₙ) branchés en parallèle, on divise ensuite celui-ci par le nombre (n) des circuits cascodes (4₁, 4₃, ..., 4ₙ) branchés en parallèle et on multiplie par un facteur de proportionnalité (k).

7. Dispositif (2) pour l'équilibrage de la perte de puissance d'au moins deux circuits cascodes (4₁, 4₂, .... 4ₙ) branchés en parallèle et comportant à chaque fois un commutateur semi-conducteur à blocage bas (6₁, 6₂, ..., 6ₙ) en silicium et un commutateur semi-conducteur à blocage haut (8₁, 8₂, ..., 8ₙ) en carbure de silicium, dans lequel ce dispositif (2) comporte pour chaque circuit cascode (4₁, 4₂, ..., 4ₙ) un dispositif de mesure de tension (10₁, 10₂, ..., 10ₙ), un dispositif (12₁, 12₂, ..., 12ₙ) pour la détermination d'une valeur de correction (U_{K1}, U_{K2}, ..., U_{Kn}) et un additionneur (14₁, 14₂, ..., 14ₙ), dans lequel chaque dispositif de mesure de tension (101, 10₂, ..., 10ₙ) est relié en entrée à une borne principale (D') et à une borne de référence (S') d'un commutateur semi-conducteur à blocage bas (6₁, 6₂, ..., 6ₙ) et en sortie à une entrée d'un dispositif (12₁, 12₂, ..., 12ₙ) correspondant et dans lequel chaque dispositif (12₁, 12₂, ..., 12ₙ) est relié en sortie à une entrée d'un additionneur (14₁, 14₂, ..., 14ₙ) correspondant à la deuxième entrée duquel se trouve un signal de commande (U_{St1}, U_{St2}, ..., U_{Stn}).

8. Dispositif pour l'équilibrage de la perte de puissance d'au moins deux circuits cascodes (4₁, 4₂, ..., 4ₙ) branchés en parallèle et comportant à chaque fois un commutateur semi-conducteur à blocage bas (6₁, 6₂, ..., 6ₙ) en silicium et un commutateur semi-conducteur à blocage haut (8₁, 8₂, ..., 8ₙ) en carbure de silicium, dans lequel, à chaque fois, une borne de commande (G1, ..., Gn) du commutateur semi-conducteur à blocage haut (8₁, 8₂, ..., 8ₙ) est reliée au moyen d'un dispositif de découplage commandable (34₁, 34₂, ..., 34ₙ) à une borne de référence (S'₁, ..., S'ₙ) de son commutateur semi-conducteur à blocage bas (6₁, 6₂, ..., 6ₙ) correspondant, dans lequel ce dispositif (2) comporte pour chaque circuit cascode (4₁, 4₂, ..., 4ₙ) un dispositif de mesure de tension (10₁, 10₂, ..., 10ₙ) et un dispositif (12₁, 12₂, .... 12ₙ) pour la détermination d'une valeur de correction (U_{K1}, U_{K2}, ..., U_{Kn}), dans lequel chaque dispositif de mesure de tension (10₁, 10₂, ..., 10ₙ) est relié en entrée à une borne principale (D'₁, D'₂, ..., D'ₙ) et à une borne de référence (S'₁, S'₂, ..., S'ₙ) d'un commutateur semi-conducteur à blocage bas (6₁, 6₂, ..., 6ₙ) et en sortie à une entrée d'un dispositif (12₁, 12₂, ..., 12ₙ) correspondant et dans lequel chaque dispositif (12₁, 12₂, ..., 12ₙ) est relié en sortie à une entrée de commande d'un dispositif de découplage commandable (34₁, 34₂, ..., 34ₙ) correspondant.

9. Dispositif (2) selon la revendication 7 ou 8, dans lequel chaque dispositif (12₁, 12₂, ..., 12ₙ) pour la détermination d'une valeur de correction (U_{K1}, U_{K2}, ..., U_{Kn}) comporte un circuit de régulation qui est relié en entrée d'une part à une sortie d'un dispositif de formation de valeur de consigne (16) et d'autre part à une sortie d'un dispositif de mesure de tension (10₁, 10₂, ..., 10ₙ) correspondant et dans lequel le circuit de régulation comporte un comparateur (26₁, 26₂, ..., 26ₙ) avec un régulateur (28₁, 28₂, ..., 28ₙ) branché du côté aval.

10. Dispositif (2) selon la revendication 7 ou 8, dans lequel chaque dispositif (12₁, 12₂, ..., 12ₙ) pour la détermination d'une valeur de correction (U_{K1}, U_{K2}, ..., U_{Kn}) comporte en entrée un dispositif de cumul (30₁, 30₂, ..., 30ₙ) avec plusieurs entrées et en sortie un circuit de régulation qui est relié en entrée d'une part au moyen d'un diviseur (32₁, 32₂, ..., 32ₙ) à la sortie du dispositif de cumul (30₁, 30₂, ..., 30ₙ) et d'autre part à une entrée du dispositif de cumul (30₁, 30₂, ..., 30ₙ), dans lequel il y a à la deuxième entrée du diviseur (32₁, 32₂, ..., 32ₙ) le nombre (n) des circuits cascodes (4₁, 4₂, ..., 4ₙ) branchés en parallèle et dans lequel le circuit de régulation comporte un comparateur (26₁, 26₂, ..., 26ₙ) avec régulateur (28₁, 28₂, ..., 28ₙ) branché du côté aval.

11. Dispositif (2) selon la revendication 7 ou 8, dans lequel un dispositif (12) pour la détermination de plusieurs valeurs de correction (U_{K1}, U_{K2}, ..., U_{Kn}) comporte en entrée un dispositif de cumul (30) avec plusieurs entrées et en sortie plusieurs circuits de régulation, dans lequel il est branché du côté aval du dispositif de cumul (30) un diviseur (32) qui est relié en sortie à chaque fois à une entrée des circuits de régulation, dans lequel une deuxième entrée des circuits de régulation est reliée à chaque fois à une entrée du dispositif de cumul (30) et dans lequel chaque circuit de régulation comporte un comparateur (26₁, 26₂, ..., 26ₙ) avec régulateur (28₁, 28₂, ..., 28ₙ) branché du côté aval.

12. Dispositif (2) selon la revendication 9, dans lequel un dispositif de formation de valeur de consigne (16) comporte un dispositif de mesure de courant (18), un diviseur (20) et un multiplicateur (22), dans lequel le diviseur (20) relie la sortie du dispositif de mesure de courant (18) à une entrée du multiplicateur (22) et dans lequel il y a à la deuxième entrée du diviseur (20) le nombre (n) des circuits cascodes (4₁, 4₂, ..., 4ₙ) branchés en parallèle et à la deuxième entrée du multiplicateur (22) un facteur de proportionnalité (k).

13. Dispositif (2) selon l'une des revendications 7 à 12, dans lequel un MOSFET est prévu comme commutateur semi-conducteur à blocage bas (6₁,6₂,...,6ₙ).

14. Dispositif (2) selon l'une des revendications 7 à 12, dans lequel un FET à jonction est prévu comme commutateur semi-conducteur à blocage haut (8₁, 8₂, ..., 8ₙ).

15. Dispositif (2) selon l'une des revendications 7 à 12, dans lequel un transistor bipolaire est prévu à chaque fois comme commutateur semi-conducteur à blocage bas et comme commutateur semi-conducteur à blocage haut (6₁, 6₂, ..., 6ₙ ; 8₁, 8₂, ..., 8ₙ).

16. Dispositif (2) selon l'une des revendications 7 à 12, dans lequel un transistor bipolaire à grille isolée est prévu à chaque fois comme commutateur semi-conducteur à blocage bas et comme commutateur semi-conducteur à blocage haut (6₁, 6₂, ..., 6ₙ ; 8₁, 8₂, ..., 8ₙ).

## Claims

1. Method for balancing the power losses in at least two electrically parallel-connected cascode circuits (4₁,4₂,...,4ₙ), which each have a low-blocking-capability semiconductor switch (6₁,6₂,...,6ₙ) composed of silicon and a high-blocking-capability semiconductor switch (8₁,8₂,...,8ₙ) composed of silicon carbide, with an output voltage (U_{D'S'1}, U_{D'S'2}, ..., U_{D'S'n}) of each low-blocking-capability semiconductor switch (6₁,6₂,...,6ₙ) in the parallel-connected cascode circuits (4₁,4₂,...,4ₙ) being detected, with correction values (U_{K1},U_{K2},...,U_{Kn}) being established as a function of these determined output voltages (U_{D'S'1},U_{D'S'2},...,U_{D'S'n}), and with these correction values (U_{K1},U_{K2},...,U_{Kn}) being superimposed on corresponding control signals (U_{St1},U_{St2},...,U_{Stn}) for the low-blocking-capability semiconductor switches (6₁,6₂,...,6ₙ) in the parallel-connected cascode circuits (4₁,4₂,...,4ₙ).

2. Method for balancing the power losses in at least two electrically parallel-connected cascode circuits (4₁,4₂,...,4ₙ), which each have a low-blocking-capability semiconductor switch (6₁,6₂,...,6ₙ) composed of silicon and a high-blocking-capability semiconductor switch (8₁,8₂,...,8ₙ) composed of silicon carbide, with one control connection (G1,...,Gn) of the high-blocking-capability semiconductor switch (8₁,8₂,...,8ₙ) in each case being linked by means of a controllable decoupling device (34₁,34₂,...,34ₙ) to a reference connection (S'₁,...,S'ₙ) of its corresponding low-blocking-capability semiconductor switch (6₁,6₂,...,6ₙ), with an output voltage (U_{D'S'1},...,U_{D'S'n}) of each low-blocking-capability semiconductor switch (6₁,6₂,...,6ₙ) in the parallel-connected cascode circuits (4₁,4₂,...,4ₙ) being detected, with correction values (U_{K1},U_{K2},...,U_{Kn}) being established as a function of these determined output voltages (U_{D'S'1},...,U_{D'S'n}), and with these correction values (U_{D'S'1},...,U_{D'S'n}), being supplied to corresponding controllable decoupling devices (34₁,34₂,...,34ₙ).

3. Method according to Claim 1 or 2, with the determined output voltages (U_{D'S'1},...,U_{D'S'n}) each being compared with a predetermined output voltage mean value (D_{D'S'm}), and with a correction value (U_{K1},U_{K2},...,U_{Kn}) being established from each determined control error.

4. Method according to Claim 1 or 2, with each determined output voltage (U_{D'S'1},...,U_{D'S'n}) being compared with a predetermined nominal value (U*_{D'S'}), and with a correction value (U_{D'S'1},...,U_{D'S'n}) being established from each determined control difference.

5. Method according to Claim 3, with the determined output voltages (U_{D'S'1},...,U_{D'S'n}) being added up in order to establish an output voltage mean value (U_{D'S'm}), and the sum values being divided by the number of determined output voltages (U_{D'S'1},...,U_{D'S'n}).

6. Method according to Claim 4, with a total current (I_{L}) for the parallel-connected cascode circuits (4₁,4₂,...,4ₙ) being measured in order to establish a nominal value (U*_{D'S'}), and with this subsequently being divided by the number (n) of parallel-connected cascode circuits (4₁,4₂,...,4ₙ), and multiplied by a proportionality factor (k).

7. Apparatus (2) for balancing the power losses in at least two electrically parallel-connected cascode circuits (4₁,4₂,...,4ₙ), which each have a low-blocking-capability semiconductor switch (6₁,6₂,...,6ₙ) composed of silicon and a high-blocking-capability semiconductor switch (8₁,8₂,...,8ₙ) composed of silicon carbide, with this apparatus (2) having, for each cascode circuit (4₁,4₂,...,4ₙ), a voltage measurement device (10₁,10₂,...,10ₙ), a device (12₁,12₂,...,12ₙ) for establishing a correction value (U_{K1},U_{K2},...,U_{Kn}), and an adder (14₁,14₂,...,14ₙ), with each voltage measurement device (10₁,10₂,...,10ₙ) being linked on the input side to a main connection (D') and to a reference connection (S') of a low-blocking-capability semiconductor switch (6₁,6₂,...,6ₙ), and being linked on the output side to an input of a corresponding device (12₁,12₂,...,12ₙ), and with each device (12₁,12₂,...,12ₙ) being connected on the output side to an input of a corresponding adder (14₁,14₂,...,14ₙ), to whose second input a control signal (U_{St1},U_{St2},...,U_{Stn}) is applied.

8. Apparatus for balancing the power losses in at least two electrically parallel-connected cascode circuits (4₁,4₂,...,4ₙ), which each have a low-blocking-capability semiconductor switch (6₁,6₂,...,6ₙ) composed of silicon and a high-blocking-capability semiconductor switch (8₁,8₂,...,8ₙ) composed of silicon carbide, with a control connection (G1,...,Gn) of the high-blocking-capability semiconductor switches (8₁,8₂,...,8ₙ) being linked by means of a controllable decoupling device (34₁,34₂,...,34ₙ) to a reference connection (S'₁,...,S'ₙ) of its corresponding low-blocking-capability semiconductor switch (6₁,6₂,...,6ₙ), with this apparatus (2) having, for each cascode circuit (4₁,4₂,...,4ₙ), a voltage measurement device (10₁,10₂,...,10ₙ) and a device (12₁,12₂,...,12ₙ) for establishing a correction value (U_{K1},U_{K2},...,U_{Kn}), with each voltage measurement device (10₁,10₂,...,10ₙ) being linked on the input side to a main connection (D'₁,D'₂,...,D'ₙ) and to a reference connection (S'₁,S'₂,...,S'ₙ) of a low-blocking-capability semiconductor switch (6₁,6₂,...,6ₙ), and being linked on the output side to an input of a corresponding device (12₁,12₂,...,12ₙ), and with each device (12₁,12₂,...,12ₙ) being connected on the output side to a control input of a corresponding controllable decoupling device (34₁,34₂,...,34ₙ).

9. Apparatus (2) according to Claim 7 or 8, with each device (12₁,12₂,...,12ₙ) having a control loop in order to establish a correction value (U_{K1},U_{K2},...,U_{Kn}), which device (12₁,12₂,...,12ₙ) is linked on the input side firstly to an output of a nominal value former (16) and secondly to an output of a corresponding voltage measurement device (10₁,10₂,...,10ₙ), and with the control loop having a comparator (26₁,26₂,...,26ₙ) with a downstream regulator (28₁,28₂,...,28ₙ).

10. Apparatus (2) according to Claim 7 or 8, with each device (12₁,12₂,...,12ₙ) for establishing a correction value (U_{K1},U_{K2},...,U_{Kn}) having, on the input side, an adding device (30₁,30₂,...,30ₙ) with a plurality of inputs and having, on the output side, a control loop which is linked on the input side firstly by means of a divider (32₁,32₂,...,32ₙ) to the output of the adding device (30₁,30₂,...,30ₙ) and secondly to an input of the adding device (30₁,30₂,...,30ₙ), with the number (n) of parallel-connected cascode circuits (4₁,4₂,...,4ₙ) being applied to the second input of the divider (32₁,32₂,...,32ₙ), and with the control loop having a comparator (26₁,26₂,...,26ₙ) with downstream regulators (38₁,38₂,...,38ₙ).

11. Apparatus (2) according to Claim 7 or 8, with a device (12) for establishing a plurality of correction values (U_{K1},U_{K2},...,U_{Kn}) having, on the input side, an adding device (30) with a plurality of inputs and having, on the output side, a plurality of control loops, with the adding device (30) having a downstream divider (32) which is in each case connected on the output side to an input of the control loop, with a second input of the plurality of control loops in each case being linked to an input of the adding device (30), and with each control loop having a comparator (26₁,26₂,...,26ₙ) with a downstream regulator (28₁,28₂,...,28ₙ).

12. Apparatus according to Claim 9, with a nominal value former (16) having a current measurement device (18), a divider (20) and a multiplier (22), with the divider (20) linking the output of the current measurement device (18) to an input of the multiplier (22), and with the number (n) of parallel-connected cascode circuits (4₁,4₂,...,4ₙ) being applied to the second input of the divider (20), and a proportionality factor (k) being applied to the second input of the multiplier (22).

13. Apparatus (2) according to one of Claims 7 to 12, with a MOSFET being provided as a low-blocking-capability semiconductor switch (6₁,6₂,...,6ₙ).

14. Apparatus (2) according to one of Claims 7 to 12, with a junction FET being provided as a high-blocking-capability semiconductor switch (8₁,8₂,...,8ₙ).

15. Apparatus (2) according to one of Claims 7 to 12, with a bipolar transistor in each case being provided as a low-blocking-capability semiconductor switch and as a high-blocking-capability semiconductor switch (6₁,6₂,...,6ₙ; 8₁,8₂,...,8ₙ).

16. Apparatus (2) according to one of Claims 7 to 12, with a insulated gate bipolar transistor in each case being provided as a low-blocking-capability semiconductor switch and as a high-blocking-capability semiconductor switch (6₁,6₂,...,6ₙ; 8₁,8₂,...,8ₙ).
